# EUROPEAN PATENT APPLICATION

(11) **EP 2 693 631 A2**
(43) Date of publication of application: **05.02.2014**
(21) Application number: 13178127.0
(22) Date of filing: 26.07.2013
(51) Int. Cl.: H03F 1/02, H03F 1/30

(54) **Apparatus, method and mobile terminal for reducing power consumption on power amplifier**

(30) Priority: 30.07.2012 CN 201210266714
(71) Applicant: Huawei Device Co., Ltd., Longgang District Shenzhen Guangdong 518129 (CN)
(72) Inventor: An, Wanji, 518129 Shenzhen (CN); Pan, Guangsheng, 518129 Shenzhen (CN)
(74) Representative: Pfenning, Meinig & Partner GbR

(57) **Abstract**

The present invention applies to the field of energy saving, and in particular, to an apparatus, a method, and a mobile terminal for reducing power consumption on a power amplifier. In embodiments of the present invention, a controller is separately connected to a temperature detector and a voltage converter. The controller searches for, according to a temperature of the power amplifier detected by the temperature detector, a voltage compensation value corresponding to the temperature, and controls, according to the voltage compensation value, the voltage converter to output a power voltage that is capable of improving efficiency of the power amplifier. This may enable the power amplifier to work in an optimal efficiency at any temperature, and greatly reduce the power consumption of the power amplifier.

## Description

### TECHNICAL FIELD

The present invention relates to the field of energy saving, and in particular, to an apparatus, a method, and a mobile terminal for reducing power consumption on a power amplifier.

### BACKGROUND

A mobile terminal product has high requirements for power consumption. Reducing power consumption on a battery-powered mobile terminal may increase the battery life of the mobile terminal. As a main power consumption part of an entire apparatus, power consumption of the power amplifier may account for up to 50% or even more in prevailed 3G mobile terminals. When the output power and the input power of a mobile terminal are the same as those of another mobile terminal, respectively, the higher the efficiency of the power amplifier is for one mobile terminal, the smaller the power consumption is for the mobile terminal. Therefore, optimizing the efficiency of the power amplifier has an outstanding effect on reducing power consumption on an overall system.

Currently, the power amplifier adopts the same power voltage at any temperature. In this way, at a common temperature and a low temperature, a working voltage of the power amplifier should conform to various specifications that can be conformed at a high temperature. Consequently, efficiency of the power amplifier at a common temperature and a low temperature does not reach the most ideal extent, thereby going against a decrease in the power consumption on the power amplifier.

### SUMMARY

The purpose of the present invention is to provide an apparatus for reducing power consumption on a power amplifier, aiming at solving the problem of high power consumption on the power amplifier, which is caused because the power voltage for a power amplifier on a mobile terminal cannot be adjusted with changes in a temperature.

The present invention is implemented through an apparatus for reducing power consumption on a power amplifier that is connected to a power amplifier, where the apparatus for reducing power consumption on a power amplifier includes:
a temperature detector, configured to detect a temperature of the power amplifier;
a voltage converter, connected to the power amplifier and configured to adjust a power voltage of the power amplifier; and
a controller, separately connected to the temperature detector and the voltage converter, configured to search for, according to the temperature of the power amplifier detected by the temperature detector, a voltage compensation value corresponding to the temperature, and configured to control, according to the voltage compensation value, the voltage converter to output a power voltage that is capable of improving efficiency of the power amplifier.

Another purpose of the present invention is to provide a method for reducing power consumption based on the apparatus for reducing power consumption on a power amplifier, where the method for reducing power consumption includes the following steps:
detecting a temperature of the power amplifier; and
searching for, according to the temperature of the power amplifier, a voltage compensation value corresponding to the temperature, and controlling, according to the voltage compensation value, a voltage converter to output a power voltage that is capable of improving efficiency of the power amplifier.

Another purpose of the present invention is to provide a mobile terminal that includes the apparatus for reducing power consumption on a power amplifier.

In the present invention, a controller is separately connected to a temperature detector and a voltage converter. The controller searches for, according to a temperature of the power amplifier detected by the temperature detector, a voltage compensation value corresponding to the temperature, and controls, according to the voltage compensation value, the voltage converter to output a power voltage that is capable of improving efficiency of the power amplifier. This may enable the power amplifier to work in an optimal efficiency at any temperature, and greatly reduce power consumption of the power amplifier.

### BRIEF DESCRIPTION OF DRAWINGS

FIG. 1 is a circuit module diagram of an apparatus for reducing power consumption on a power amplifier according to an embodiment of the present invention; and
FIG. 2 is a flowchart of a method for reducing power consumption on a power amplifier according to an embodiment of the present invention.

### DESCRIPTION OF EMBODIMENTS

To make the objectives, technical solutions, and advantages of the present invention more clear, the following further describes the present invention in detail with reference to the accompanying drawings and embodiments. It should be understood that the specific embodiment is only used to explain the present invention and is not intended to limit the present invention.

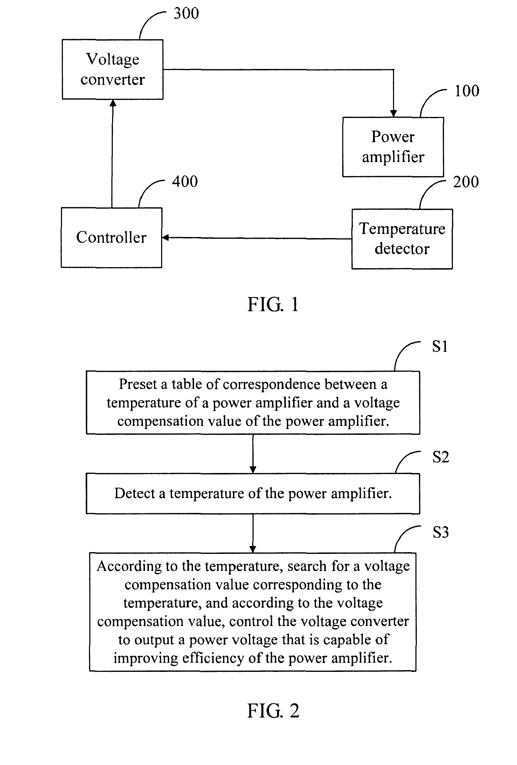

FIG. 1 shows a structure of a circuit module in an apparatus for reducing power consumption on a power amplifier. For ease of description, only a part relevant to the embodiment of the present invention is shown. The detailed descriptions are as follows:

An apparatus for reducing power consumption on a power amplifier that is connected to a power amplifier 100 is provided. The apparatus includes:
a temperature detector 200, configured to detect a temperature of the power amplifier 100;
a voltage converter 300, connected to the power amplifier 100 and configured to adjust a power voltage of the power amplifier 100; and
a controller 400, separately connected to the temperature detector 200 and the voltage converter 300, configured to search for, according to the temperature of the power amplifier 100 detected by the temperature detector 200, a voltage compensation value corresponding to the temperature, and configured to control, according to the voltage compensation value, the voltage converter 300 to output a power voltage that is capable of improving efficiency of the power amplifier 100.

As an embodiment of the present invention, the temperature detector 200 is a temperature sensor. FIG. 2 is a flowchart of a method for reducing power consumption on a power amplifier. For ease of description, only a part relevant to the embodiment of the present invention is shown. The detailed descriptions are as follows: A method for reducing power consumption based on an apparatus for reducing power consumption of a power amplifier is provided. The method includes the following steps:

Step S1: Preset a table of correspondence between the temperature of the power amplifier and the voltage compensation value of the power amplifier.
Step S1 is a preparation work that is performed in advance.
Step S2: Detect a temperature of the power amplifier.
Step S3: According to the temperature of the power amplifier, search for a voltage compensation value corresponding to the temperature, and according to the voltage compensation value, control a voltage converter to output a power voltage that is capable of improving efficiency of the power amplifier.
Step S3 specifically includes:
   according to the table of the correspondence, search for the voltage compensation value corresponding to the temperature, and according to the voltage compensation value,
   control the voltage converter to output the power voltage that is capable of improving the efficiency of the power amplifier.

An embodiment of the present invention further provides a mobile terminal that includes an apparatus for reducing power consumption on a power amplifier.

In the embodiment of the present invention, a controller is separately connected to a temperature detector and a voltage converter; the controller searches for, according to a temperature of a power amplifier detected by the temperature detector, a voltage compensation value corresponding to the temperature, and controls, according to the voltage compensation value, the voltage converter to output a power voltage that is capable of improving efficiency of the power amplifier. This may enable the power amplifier to work in an optimal efficiency at any temperature, and greatly reduce the power consumption of the power amplifier.

The foregoing descriptions are merely exemplary embodiments of the present invention, but are not intended to limit the present invention. Any variation, equivalent replacement, and improvements made within the principle of the present invention shall fall within the protection scope of the present invention

## Claims

1. An apparatus for reducing power consumption on a power amplifier, connected to a power amplifier, wherein the apparatus for reducing power consumption on a power amplifier comprises:
a temperature detector, configured to detect a temperature of the power amplifier;
a voltage converter, connected to the power amplifier and configured to adjust a power voltage of the power amplifier; and
a controller, separately connected to the temperature detector and the voltage converter, configured to search for, according to the temperature of the power amplifier detected by the temperature detector, a voltage compensation value corresponding to the temperature, and configured to control, according to the voltage compensation value, the voltage converter to output a power voltage that is capable of improving efficiency of the power amplifier.

2. The apparatus for reducing power consumption on a power amplifier according to claim 1, wherein the temperature detector is a temperature sensor.

3. A method for reducing power consumption based on the apparatus for reducing power consumption on a power amplifier according to claim 1, wherein the method for reducing power consumption comprises the following steps:
detecting a temperature of the power amplifier; and
searching for, according to the temperature of the power amplifier, a voltage compensation value corresponding to the temperature, and controlling, according to the voltage compensation value, a voltage converter to output a power voltage that is capable of improving efficiency of the power amplifier.

4. The method for reducing power consumption according to claim 3, wherein before the step of detecting a temperature of a power amplifier, or searching for, according to the temperature of the power amplifier, a voltage compensation value corresponding to the temperature, and controlling, according to the voltage compensation value, the voltage converter to output a power voltage that is capable of improving efficiency of the power amplifier, the method further comprises:
presetting a table of correspondence between the temperature of the power amplifier and the voltage compensation value of the power amplifier.

5. The method for reducing power consumption according to claim 4, wherein the searching for, according to the temperature of the power amplifier, a voltage compensation value corresponding to the temperature, and the controlling, according to the voltage compensation value, the voltage converter to output a power voltage that is capable of improving efficiency of the power amplifier, is specifically:
searching for, according to the temperature of the power amplifier and the table of the correspondence, the voltage compensation value corresponding to the temperature; and controlling, according to the voltage compensation value, the voltage converter to output the power voltage that is capable of improving the efficiency of the power amplifier.

6. A mobile terminal, wherein the mobile terminal comprises a power amplifier and an apparatus for reducing power consumption on a power amplifier that is connected to the power amplifier according to claims 1 to 2.
